# EUROPÄISCHE PATENTSCHRIFT

(11) **EP 0 627 554 B1**
(45) Veröffentlichungstag und Bekanntmachung des Hinweises auf die Patenterteilung: **28.05.1997**
(21) Anmeldenummer: 94105754.9
(22) Anmeldetag: 14.04.1994
(51) Int. Cl.: F02P 7/03, H03K 17/10, H03K 17/78, G02B 6/42

(54) **Verteilerloses Zündsystem mit lichtgesteuerten Hochspannungsschaltern**
Distributorless ignition system using light-controlled high voltage switches
Système d'allumage sans distributeur avec des commutateurs de haute tension contrôlés par lumière

(30) Priorität: 28.05.1993 DE 4317962; 24.02.1994 DE 4405994
(43) Veröffentlichungstag der Anmeldung: 07.12.1994
(73) Patentinhaber: Bayerische Motoren Werke Aktiengesellschaft, 80788 München (DE)
(72) Erfinder: Koelter, Martin, D-81549 München (DE)
(74) Vertreter: Bullwein, Fritz

(56) Entgegenhaltungen:
- EP-A- 0 431 846
- EP-A- 0 463 842
- WO-A-92/07188
- DE-A- 3 333 111
- DE-A- 3 731 393
- GB-A- 2 229 315
- US-A- 4 577 114
- US-A- 5 109 829
- US-A- 5 195 496

## Beschreibung

Die Erfindung bezieht sich auf ein verteilerloses Zündsystem nach dem Oberbegriff des Patentanspruchs 1.

Ein derartiges Zündsystem ist aus der US 5,109,829 A bekannt. Die steuerbaren Halbleiterschalter, die mehrere Halbleiterbauelemente enthalten, sind in der Zuleitung zur jeweiligen Zündkerze angeordnet. Bedingt durch die Anordnung der Halbleiterbauelemente hintereinander ist es notwendig, entweder mehrere Lichtquellen oder zwischen Lichtquelle und Halbleiterbauelemente Lichtführungselemente anzuordnen. Es kann sich dabei um eine Linse oder einen kegelförmigen Lichfführungskanal handeln. Allen Ausführungsformen gemeinsam ist der hohe Bauteileaufwand verbunden mit einem erheblichen Gewicht der gesamten Anordnung, die einen Einsatz beispielsweise in einem Fahrzeug angesichts der dort i.d.R. herrschenden gedrängten Bauverhältnisse erschweren, wenn nicht sogar unmöglich machen.

Der Erfindung liegt die Aufgabe zugrunde, ein Zündsystem der eingangs genannten Art zu schaffen, das sich durch ein geringes Bauvolumen auszeichnet.

Die Erfindung löst diese Aufgabe durch die kennzeichnenden Merkmale des Patentanspruchs 1.

Durch die Anordnung der Halbleiterbauelemente um das lichtemittierende Element herum hängt die Zahl der optisch durch das lichtemittierende Element zündbaren Halbleiterbauelemente nicht vom Abstand zu dem Element, sondern von der Größe der Oberfläche des lichtemittierenden Elements ab. Anstelle einer LED wie beim bekannten Hochspannungsschalter bietet sich hierfür eine Xenon-Röhre an. Diese besitzt eine hohe Lichtstärke bei gutem Zündverhalten und ist einfach und robust im Aufbau und der Handhabung.

Die bei der Erfindung ebenfalls vorgesehene Integration der Halbleiterschalter im Zündkerzen-Anschlußstecker trägt deutlich zu einer Verringerung des Bauraums bei. Es ist zwar aus der DE 33 33 111 A bekannt, bei einem auf Hochfrequenzbasis arbeitenden Zündsystem einen elektronischen Schalter unmittelbar im Kerzenstecker anzuordnen. Eine konstruktive Ausgestaltung ergibt sich aus dieser Druckschrift ebensowenig wie der Hinweis, eine entsprechende Anordnung bei einem mit mehren kaskadenartig hintereinander geschalteten, optisch zündbaren Halbleiterbauelementen einzusetzen.

In der Zeichnung ist ein Ausführungsbeispiel der Erfindung dargestellt. Es zeigt
- Fig. 1: ein Schaltbild zur Erläuterung der schaltungstechnischen Realisierung der Erfindung
- Fig. 2: eine konstruktive Ausführung des erfindungsgemäßen Zündsystems und
- Fig.3: einen im Zündsystem von Fig. 1 und 2 verwendeten Hochspannungsschalter in der Abwicklung und
- Fig.4: den Hochspannungsschalter von Fig. 3 eingebaut in einen Zündkerzenstecker und im Querschnitt.

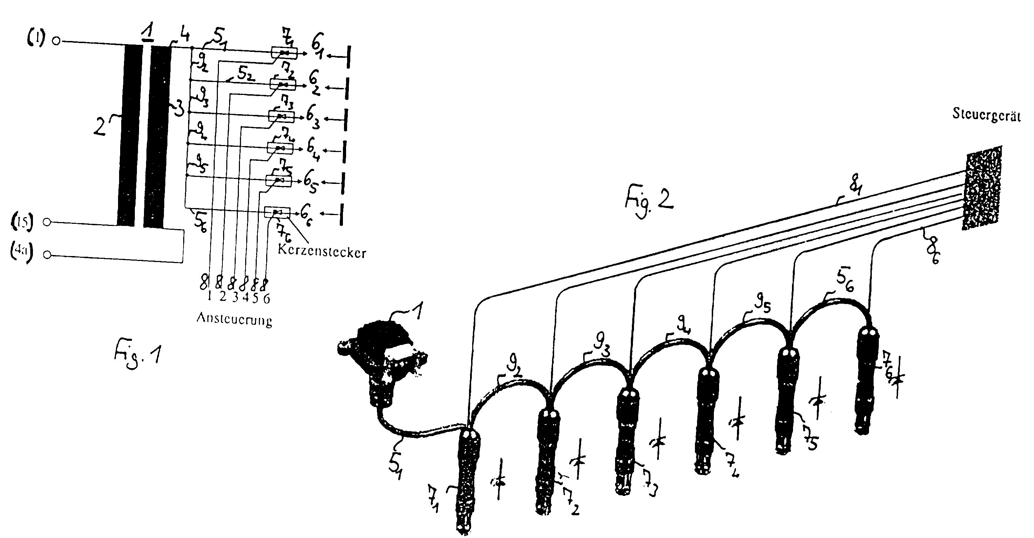

Das in Fig. 1 als Schaltbild dargestellte verteilerlose Zündsystem zeigt eine Zündspule 1 mit einer Primärspule 2 und einer Sekundärspule 3. An einem Anschluß 4 der Sekundärspule sind parallel Leitungen 5₁ bis 5₆ angeschlossen, die zu als Funkenstrecken dargestellten Zündkerzen 6₁ bis 6₆ führen. Unmittelbar vor den jeweiligen Zündkerzen ist ein steuerbarer Halbleiterschalter 7₁ bis 7₆ in einem nicht im Detail dargestellten Zündkerzenstecker eingeschaltet, dessen Steuerleitungen 8₁ bis 8₆ zu einem nicht dargestellten Steuergerät führen.

Die Steuerleitungen 8₁ bis 8₆ sind als Lichtleiter ausgebildet und führen zur Steuerelektrode des zugehörigen Thyristors 7₁ bis 7₆.

Zum Zünden der Zündkerzen 6₁ bis 6₆ wird durch das Steuergerät der Stromfluß durch die Primärspule 2 unterbrochen. Der sich sekundärseitig am Anschluß 4 ergebende Zündfunke steht an jeder der Leitungen 5₁ bis 5₆ gleichzeitig an. Die Auswahl der tatsächlich wirksamen Zündkerze erfolgt durch Ansteuerung des vorgeschalteten Thyristors 7₁ bis 7₆ über die Steuerleitung 8₁ bis 8₆ ebenfalls durch das Steuergerät. Je nach Ausgestaltung ist es möglich jeweils nur eine der zwei Zündkerzen gleichzeitig zu zünden. Ersteres gilt dann, wenn in dem jeweils im Arbeitstakt befindlichen Zylinder der Brennkraftmaschine nur ein, letzteres wenn zwei Zündkerzen gleichzeitig gezündet werden sollen. Damit wird es möglich, mit nur einer Zündspule mehrere, i.d.R. mindestens vier, vorzugsweise sechs bzw. acht Zündkerzen zu bedienen. Es ist ohne weiteres zu erkennen, daß der schaltungstechnische und konstruktive Aufbau gering gehalten werden kann.

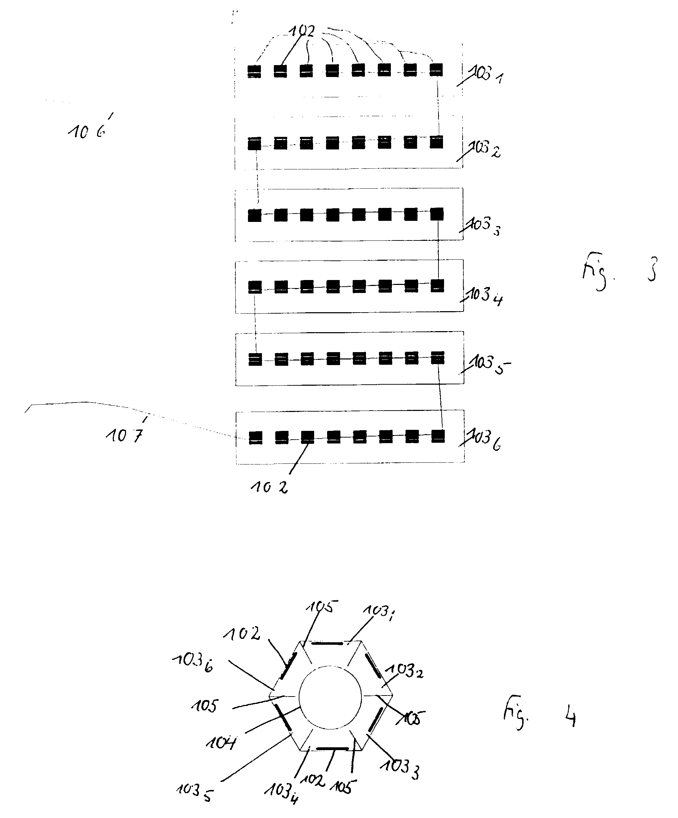

Dies ergibt sich auch aus Fig. 2, in der der konstruktive Aufbau des in Fig. 1 dargestellten Zündsystems wiedergegeben ist. Die elektrische Verbindung zwischen den kerzensteckern 7₁ bis 7₆ erfolgt durch elektrische Leitungen, die in Fig. 1 mit 9₂ bis 9₅ bezeichnet sind und die die Verbindung zwischen den parallelen Zweigen 5₁ bis 5₆ herstellen. Das zugehörige Steuergerät ist dabei schematisch dargestellt. Ebenfalls schematisch gezeigt sind die Halbleiterschalter mit ihrem Schaltsymbol, die in die Zündkerzenstecker 7₁ bis 7₆ integriert sind und die durch die Steuerleitungen 8₁ bis 8₆ gezündet werden. Hierzu ist in dem Steuergerät jeder der Steuerleitungen 81 bis 86 eine Leuchtdiode (nicht dargestellt) vorgeschaltet, die gleichzeitig mit dem Unterbrechen des Stromflusses durch die Primärspule 2 die jeweils zu aktivierende Zündkerze aktiviert ist.

Der in Fig. 3 dargestellte Hochspannungsschalter 101 wirkt als Thyristor und besteht aus insgesamt 48 Halbleiterbauelementen, die in sechs Reihen zu acht Elementen auf Trägerplatten 103₁ bis 103₆ angeordnet sind. Jeder der Halbleiterbauelemente besitzt eine Sperrspannung von 1200 V. Die Bauelemente sind mäanderförmig wie dargestellt hintereinandergeschaltet. Die Trägerplatten 103₁ bis 103₆ sind, wie in Fig. 2 gezeigt, zu einem Sechskant miteinander verbunden und verklebt. Sie umgeben eine Xenonröhre 104 konzentrisch. Zwischen jeweils zwei benachbarten Trägerplatten sind Stege 105 eingesetzt, um einen Spannungsüberschlag zwischen zwei Halbleiterbauelementen auf unterschiedlichen Trägerplatten zu verhindern. Der gesamte Raum zwischen der Xenonröhre und den Trägerplatten 103₁ bis 103₆ ist mit durchsichtigem, hochisoliertem Gießharz vergossen.

Die in Fig. 4 dargestellt Anordnung befindet sich in einem nicht gezeigten Zündkerzenanschlußstecker, dessen Hochspannungsanschluß mit dem zur Trägerplatte 103₁ führenden elektrischen Leiter 106 verbunden ist und dessen Zündkerzenanschlußkontakt (nicht dargestellt) mit dem Ende dieses Leiters 107 verbunden ist.

Um die am Leiter 107 angeschlossene Zündkerze mit der Hochspannung, d.h. dem Hochspannungsanschluß einer nicht dargestellten Zündspule zu verbinden, wird Xenonröhre 104 gezündet. De Halbleiterbauelemente 102 werden damit sämtlich leitend. Ein Hochspannungsimpuls kann nun vom Leiter 106 durch die Halbleiterbauelemente 102 zum Leiter 107 und damit zur Zündkerze gelangen. Beim anschließenden Stromdurchgang durch Null werden die Halbleiterbauelemente wieder nicht-leitend und können erst durch einen erneuten Zündvorgang der Xenonröhre gezündet werden.

Für eine nicht dargestellte Brennkraftmaschine mit mehreren Zylindern genügt eine einzige Zündspule als Hochspannungsquelle. Die zylinderselektive Zuordnung der Hochspannung zu den einzelnen Zylindern erfolgt mit Hilfe des dargestellten Hochspannungsschalter für jeden der Zylinder. Durch gleichzeitige Zündung der nungsschalters für zwei Zylinder ist es auch möglich, z.B. beim Kaltstart zwei Zündkerzen gleichzeitig zu zünden. Gegenüber einem Zündsystem, bei dem jeder Zylinder mit einer Einzelspulenzündung versehen ist, ergibt sich damit eine erhebliche Gewichts- und Kostenersparnis, da nur noch eine gemeinsame Zündspule und für jede Zündkerze ein Zündkerzenstecker vorgesehen werden muß, der einen Hochspannungsschalter gemäß der Erfindung aufweist.

## Patentansprüche

1. Verteilerioses Zündsystem für eine Brennkraftmaschine mit einem Steuergerät und mit einer Zündspule, bestehend aus einer durch das Steuergerät geschalteten Primärspule und einer Sekundärspule mit mehreren an einem Anschluß an einem Ende der Zündspule angeschlossenen Zündkerzen, mit einem in der elektrischen Verbindung von diesem Anschluß zur jeweiligen Zündkerze eingeschalteten optisch steuerbaren Halbleiterschalter, der mehrere hintereinandergeschaltete Halbleiterbauelemente (102) enthält, wobei die Halbleiterbauelemente (102) des Halbleiterschalters für die zu zündende Zündkerze durch ein gemeinsames lichtemittierendes Element (104) und zumindest annähernd gleichzeitig mit der Primärspule durch das Steuergerät aktivierbar sind, dadurch gekennzeichnet, daß die Halbleiterschalter in einem in die Zuleitung zu der jeweiligen Zündkerze eingeschalteten Zündkerzenanschlußstecker integriert sind und daß die Halbleiterbauelemente (102) um das Lichtemittierende Element (104) herum angeordnet sind und zumindest annähernd denselben Abstand davon besitzen.

2. Zündsystem nach Anspruch 1, dadurch gekennzeichnet, daß das lichtemittierende Element (104) eine Längsrichtung definiert und daß jeweils mehrere Halbleiterschalter (102) in einer Reihe hintereinander und mehrere solcher Reihen parallel zueinander und zu dem in Längsrichtung verlaufenden lichtemittierenden Element (104) angeordnet sind.

3. Zündsystem nach Anspruch 2, dadurch gekennzeichnet daß die Reihen der Halbleiterbauelemente (102) um das lichtemittierende Element (104) herum geschlossen angeordnet sind.

4. Zündsystem nach Anspruch 2 oder 3, dadurch gekennzeichnet, daß die Reihen gegenseitig durch lichtundurchlässige Stege (105) voneinander optisch getrennt sind.

5. Zündsystem nach einem der Ansprüche 1 bis 4, dadurch gekenzeichnet, daß der Raum zwischen dem lichtemittierenden Element (104) und den Halbleiterbauelementen (102) durch einen lichtdurchlässigen Isolator ausgefüllt ist.

## Claims

1. A distributor-less ignition system for an internal combustion engine, comprising a control device and an ignition coil made up of a primary coil connected by the control device and a secondary coil with a number of spark plugs connected to a terminal at one end of the ignition coil, with an optically controllable semiconductor switch containing a number of series-connected semiconductor elements (102) and inserted in the electric connection from the first-mentioned connection to the respective spark plug, wherein the semiconductor elements (102) of the semiconductor switch for the spark plug to be ignited are activated by the control device via a common light-emitting element (104), at least approximately simultaneously with the primary coil, **characterised in that** the semiconductor switch is incorporated in a spark-plug connector inserted in the lead to the respective spark plug, and the semiconductor components (102) are disposed around the light-emitting element (104) and are at least approximately at the same distance therefrom.

2. An ignition system according to claim 1, **characterised in that** the light-emitting element (104) defines a longitudinal direction and a number of semiconductor switches (102) are disposed in series in each row and a number of such rows are disposed parallel to one another and to the light-emitting element (104), which extends in the longitudinal direction.

3. An ignition system according to claim 2, **characterised in that** the rows of semiconductor components (102) are disposed around and enclose the light-emitting element (104).

4. An ignition system according to claim 2 or 3, **characterised in that** the rows are optically separated from one another by opaque webs (105).

5. An ignition system according to any of claims 1 to 4, **characterised in that** the space between the light-emitting element (104) and the semiconductor elements (102) is filled with a light-transmitting insulator.

## Revendications

1. Système d'allumage sans distributeur pour moteur à combustion interne comportant un appareil de commande et une bobine d'allumage, système composé d'un enroulement primaire commuté par l'appareil de commande et d'un enroulement secondaire, avec plusieurs bougies d'allumage raccordées à une borne à une extrémité de la bobine d'allumage, un interrupteur à semi-conducteurs à commande optique branché dans la liaison électrique entre le branchement ci-dessus et la bougie respective, et qui comporte plusieurs éléments semi-conducteurs (102) branchés les uns derrière les autres, les éléments semi-conducteurs (102) de l'interrupteur à semi-conducteurs étant branchés pour la bougie à déclencher, par un élément photoémetteur commun (104) et au moins de manière activable pratiquement simultanément avec l'enroulement primaire par l'appareil de commande,
caractérisé en ce que
l'interrupteur à semi-conducteurs est intégré au connecteur de bougie d'allumage branché dans la ligne d'alimentation de la bougie d'allumage respective et,
les éléments semi-conducteurs (102) sont disposés autour de l'élément photoémetteur (104) et présentent au moins approximativement la même distance par rapport à celui-ci.

2. Système d'allumage selon la revendication 1,
caractérisé en ce que
l'élément photoémetteur (104) définit une direction longitudinale et chaque fois plusieurs interrupteurs semi-conducteurs (102) sont branchés en série et plusieurs de ces séries sont branchées en parallèle et sont prévues par rapport à l'élément photoémetteur (104), dirigé dans la direction longitudinale.

3. Système d'allumage selon la revendication 2,
caractérisé en ce que
les rangées des composants semi-conducteurs (102) sont bouclées autour de l'élément photoémetteur (104).

4. Système d'allumage selon la revendication 2 ou 3,
caractérisé en ce que
les rangées sont séparées optiquement les unes des autres par des branches opaques (105).

5. Système d'allumage selon l'une des revendications 1 à 4,
caractérisé en ce que
le volume compris entre l'élément photoémetteur (104) et les composants semi-conducteurs (102) est rempli par un isolant transparent.
